# EUROPÄISCHE PATENTSCHRIFT

(11) **EP 0 886 999 B1**
(45) Veröffentlichungstag und Bekanntmachung des Hinweises auf die Patenterteilung: **08.09.1999**
(21) Anmeldenummer: 97917250.9
(22) Anmeldetag: 04.03.1997
(51) Int. Cl.: H05K 9/00

(54) **ABDECKVORRICHTUNG MIT NIEDRIGER BAUHÖHE FÜR ELEKTROMAGNETISCH ABGESCHIRMTE METALLISCHE GEHÄUSE**
LOW COVER UNIT FOR ELECTROMAGNETICALLY SCREENED METAL HOUSINGS
DISPOSITIF DE RECOUVREMENT DE FAIBLE HAUTEUR POUR BOITIERS METALLIQUES A BLINDAGE ELECTROMAGNETIQUE

(30) Priorität: 12.03.1996 DE 29604600 U
(43) Veröffentlichungstag der Anmeldung: 30.12.1998
(73) Patentinhaber: SIEMENS AKTIENGESELLSCHAFT, 80333 München (DE)
(72) Erfinder: KURRER, Siegfried, D-90449 Nürnberg (DE); KÖRBER, Werner, D-91282 Betzenstein (DE); BILLENSTEIN, Ernst, D-91593 Burgbernheim (DE); SCHAFFER, Kurt-Michael, D-90542 Eckental (DE)
(86) Internationale Anmeldenummer: DE9700394
(87) Internationale Veröffentlichungsnummer: WO9734457

(56) Entgegenhaltungen:
- EP-A- 0 629 111
- US-A- 5 490 043

## Beschreibung

Um eine störungsfreie Funktion von elektrischen Schaltungen und dergleichen gewährleisten zu können, ist es notwendig, diese gegen elektromagnetische Wellen abzuschirmen. Hierzu muß das Gehäuse, welches die elektrische Schaltung umgibt überwiegend aus metallischen Gehäuseteilen bestehen. Dabei verhindert die Abschirmung sowohl ein Eindringen von elektromagnetischen Wellen, als auch deren Austreten aus dem Gehäuse. Hierzu ist es erforderlich, daß zwischen den metallischen Gehäuseteilen durchgehend elektrisch leitende Verbindungen, insbesondere über Kontaktfederelemente, hergestellt werden. Abhängig von der Höhe der elektromagnetischen Frequenzen müssen diese Verbindungen möglichst lückenlos sein.

Aus dem Dokument DE 36 04 860 A1 ist eine Anordnung zur hochfrequenten Abschirmung der Frontplatte eines Geräteeinschubs eines Baugruppenträgers bekannt. Die Frontplatte weist entlang einer Längsseite eine Kontaktleiste und entlang der gegenüberliegenden Längsseite eine Halteleiste mit einer über den Rand der Frontplatte hinausragenden eingesetzten Gleitfederleiste auf. Dabei ist die Frontplatte mit der Kontaktleiste und der Halteleiste einstückig als Strangpreßprofil ausgeführt.

Die Frontplatte muß aufgrund der notwendigen Eigenstabilität eine entsprechende Plattendicke aufweisen. Dadurch ist ebenfalls die Mindestdicke und Mindesthöhe von Kontaktleiste und Halteleiste vorgegeben. Die über einen Frontverbinder auf der Rückseite der Frontplatte angebrachte Leiterplatte kann aufgrund der ins Innere ragenden Kontakt- und Halteleiste nur bis zu einem Mindestabstand in Richtung der Frontplatte bestückt werden. Insbesondere bei in Baugruppenträgern eingeschobenen Leiterplatten ist die Bestückungsfläche aber begrenzt und nicht beliebig erweiterbar. Problematisch ist dabei der durch die Höhe der Gleitfederleiste bedingte, relativ tief im Gehäuse liegende Kontaktpunkt zwischen Gleitfederleiste und einer benachbarten Kontaktleiste. Die hierdurch nach innen versetzten Bereiche der elektrischen Kontaktierung verursachen eine gewisse Beeinträchtigung der elektromagnetischen Abschirmung des Gehäuses. Elektromagnetische Wellen können somit durch die Spalten zwischen den Frontplatten eindringen und werden durch die Kontakt- und Gleitfederleisten erst relativ weit hinter der Rückseite der Frontplatten abgefangen. Je weiter aber elektromagnetische Wellen in ein Gehäuse eindringen, desto größer ist deren mögliches Störpotential.

Der Erfindung liegt die Aufgabe zugrunde, eine demgegenüber wirkungsvollere Abdeckvorrichtung zur elektromagnetischen Abschirmung des Gehäuses anzugeben.

Die Aufgabe wird gelost mit einer Abdeckvorrichtung für ein elektromagnetisch abgeschirmtes metallisches Gehäuse, insbesondere für einen Baugruppenträger mit einer Grundplatte und mindestens einer Profilleiste, welche an eine Seitenkante der Grundplatte ansetzbar ist. Die Profilleiste weist desweiteren einen annähernd orthogonal bezüglich der Ebene der Grundplatte angeordneten leistenförmigen Kontaktschenkel und einen leistenförmigen Auflageschenkel auf, welcher mit der Grundplatte verbindbar und derartig abgewinkelt ist, daß sich eine annähernde Bündigkeit der Profilleiste mit der Vorderseite der Grundplatte ergibt.

Vorteil der Abdeckvorrichtung gemäß der Erfindung ist die niedrige Höhe der separaten Profilleisten. Diese ragen nur geringfügig in eine beispielsweise auf der Rückseite der Abdeckvorrichtung orthogonal befestigte Leiterplatte. Dadurch ergibt sich auf dieser eine optimale Flächenausnutzung für Bauelemente.

Besonders vorteilhaft ist es, daß bei zwei benachbarten Abdeckvorrichtungen der Kontaktpunkt zwischen der Federprofilleiste der ersten Abdeckvorrichtung und dem Kontaktschenkel der zweiten Abdeckvorrichtung nahezu auf der Höhe der Rückseite der Grundplatten liegt. Dadurch ergibt sich eine nahezu in einer Ebene mit der Vorderseite der einzelnen Abdeckvorrichtungen bzw. anderen benachbarten Gehäuseteilen verlaufende elektrische Kontaktierung, welche eine nahezu ideale elektromagnetische Abschirmung des Gehäuses bewirkt.

Ein weiterer Vorteil der Abdeckvorrichtung gemäß der Erfindung stellt die separat gefertigte Profilleiste dar, die beispielsweise als Federprofilleiste ausgebildet sein kann. Die separate Herstellung einer Federprofilleiste ermöglicht insbesondere eine feinere Ausarbeitung des Profils als solches im Strangpreßverfahren. Somit ist bevorzugt ein einheitliches Profil und eine einheitliche Federform für alle im elektromagnetisch abgeschirmten Gehäuse notwendigen Kontaktfeder- und Profilleisten verwendbar. Somit kann an einem Gehäuse beispielsweise vorteilhaft nur noch eine einzige Ausführungsform einer Kontaktfeder eingesetzt sein. Insbesondere kann eine Profilform verwendet werden, auf die eine Kontaktfederleiste vorteilhaft aufsteckbar ist.

Weitere vorteilhafte Ausführungsformen der Erfindung sind in den entsprechenden Unteransprüchen angegeben.

Die Erfindung wird desweiteren anhand des in den nachfolgend kurz angeführten Figuren dargestellten Ausführungsbeispieles weiter erläutert. Dabei zeigt
- FIG 1: beispielhaft eine Abdeckvorrichtung gemäß der Erfindung mit einer Grundplatte und zwei an deren Seitenkanten angesetzten Profilleisten, wobei die eine Profilleiste als eine Kontaktprofilleiste und die andere als eine Federprofilleiste ausgebildet ist,
- FIG 2: beispielhaft einen Querschnitt durch die in Figur 1 dargestellte Abdeckvorrichtung, und
- FIG 3: beispielhaft eine Abdeckvorrichtung gemäß der Erfindung mit in zwei seitliche Aussparungen der Grundplatte eingelegten Profilleisten.

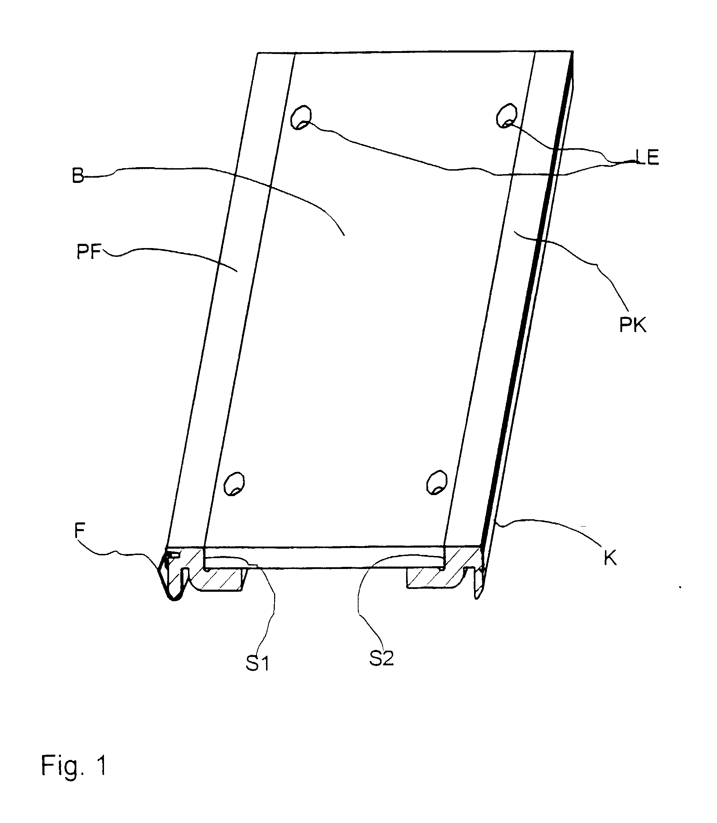

In Figur 1 ist beispielhaft eine Ausführungsform einer Abdeckvorrichtung gemäß der Erfindung mit einer Grundplatte B und zwei an deren Seitenkanten S1 und S2 angesetzten Profilleisten PK und PF dargestellt. Diese sind insbesondere durch Verschraubung oder Vernietung über Bohrungen LE mit der Grundplatte B verbunden. Dabei ist eine Profilleiste bevorzugt als eine Kontaktprofilleiste PK und die andere als eine Federprofilleiste PF mit aufgesteckter Kontaktfederleiste F ausgebildet.

Die in der in Figur 1 beispielhaft dargestellte Ausführungsform der erfindungsgemäßen Abdeckvorrichtung dient zur durchgängigen elektromagnetischen Abschirmung beispielsweise einer Vorderseite eines Gehäuses. Durch bündiges, ebenes Aneinanderreihen mehrerer derartiger Abdeckvorrichtungen wird die Kontaktfederleiste F einer ersten Abdeckvorrichtung auf die leistenförmige Kontaktfläche K der Kontaktprofilleiste PK einer benachbarten zweiten Abdeckvorrichtung gepreßt. Dadurch entsteht eine leitende elektrische Verbindung zwischen den einzelnen Abdeckvorrichtungen wodurch die elektromagnetisch abschirmende Wirkung bewirkt wird.

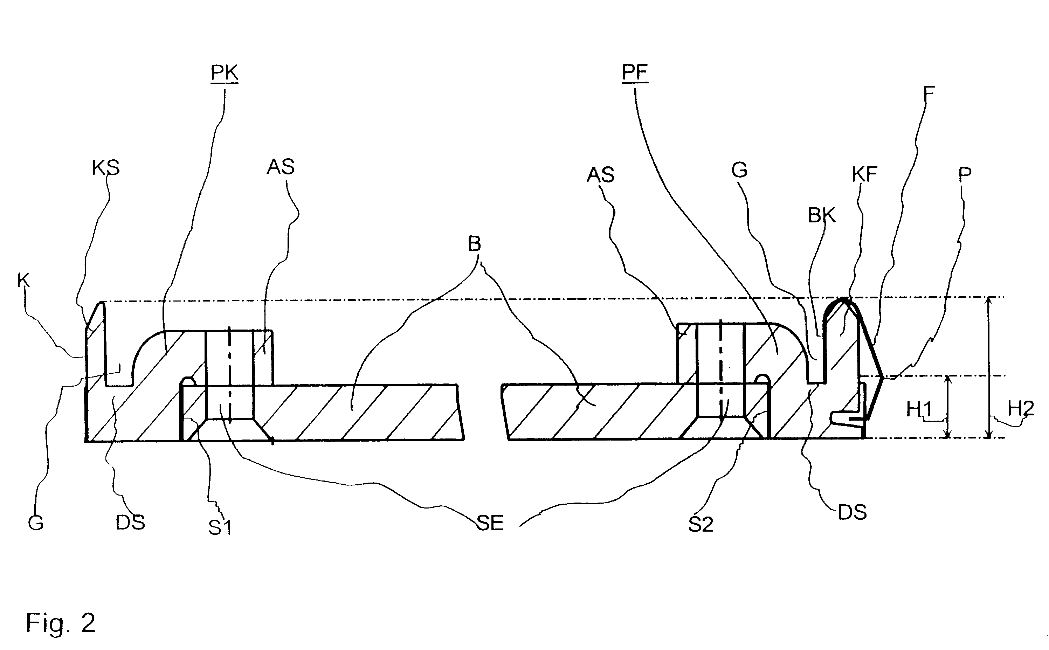

In Figur 2 ist ein Querschnitt der erfindungsgemäßen und in Figur 1 beispielhaft dargestellten Abdeckvorrichtung eines elektromagnetisch abgeschirmten metallischen Gehäuses gezeigt. Diese weist dabei eine Grundplatte B auf und mindestens eine Profilleiste PK bzw. PF, welche an eine Seitenkante S1 bzw. S2 der Grundplatte B angesetzt ist. Die Profilleisten PK bzw. PF enthalten einen bezüglich der Ebene der Grundplatte B annähernd orthogonal angeordneten leistenförmigen Kontaktschenkel KS bzw. KF, und weisen desweiteren jeweils einen leistenförmigen Auflageschenkel AS auf. Dieser ist mit der Grundplatte B verbindbar und derartig abgewinkelt, daß sich eine annähernde Bündigkeit der Außenseite der Profilleiste PK bzw. PF mit der Vorderseite der Grundplatte B ergibt.

Darüber hinaus kann vorteilhaft in einer Ausführungsform der erfindungsgemäßen Abdeckvorrichtung die Profilleiste PK bzw. PF zwischen dem Kontaktschenkel KS bzw. KF und dem Auflageschenkel AS einen annähernd bündig mit der Vorderseite der Grundplatte B abschließenden Abstandsschenkel DS aufweisen. Hierdurch ergibt sich eine Aussparung G auf der Rückseite der Profilleiste PK bzw. PF zwischen Kontaktschenkel KS bzw. KF und Auflageschenkel AS. Insbesondere mit der Ausbildung einer Profilleiste PF als Federprofilleiste sind Federelemente F auf diese aufsteckbar, insbesondere eine Kontaktfederleiste, welche von der Profilleiste PF federnd zur Seite abgespreizt sind. Die Aussparung G dient dabei vorteilhaft insbesondere der Aufnahme eines möglichst weit herunterreichenden und dem Federschenkel gegenüberliegenden Klemmbügels BK der Federelemente F.

Aufgrund der erfindungsgemäßen Gestaltung der Abdeckvorrichtung ergeben sich Kontaktschenkel KS bzw. KF mit einer besonders niedrigen Hohe H2. Diese reduziert den dadurch benötigten Raum somit auf ein Minimum. Vorteilhaft entspricht die Hohe H1 des Kontaktpunktes P der Federelemente F bei der erfindungsgemäßen Abdeckvorrichtung annähernd der Dicke der Grundplatte B. Der Kontaktpunkt P ist somit in der Regel auf der Höhe der Rückseite der Grundplatte B und liegt somit federnd und elektrisch leitend an benachbarten Gehäuseteilen an. Dadurch wird vorteilhaft eine annähernd ideal eben durchgehende elektromagnetische Abschirmung des Gehäuses bewirkt. Insbesondere kann dies eine benachbarte Abdeckvorrichtung mit einer zu einer Kontaktprofilleiste ausgebildeten Profilleiste PK sein. Dabei weist der nach hinten gerichtete leistenförmige Kontaktschenkel KS eine außen liegende Kontaktfläche K auf, die insbesondere als Gegenkontaktfläche zu Federelementen F dient.

Die Abdeckvorrichtung im Ausführungsbeispiel der Figur 2 weist beispielhaft jeweils eine Profilleiste PK und PF an zwei gegenüberliegenden Seitenkanten S1 und S2 der Grundplatte B auf. Die Profilleisten PK und PF sind insbesondere über deren Auflageschenkel AS mit der Grundplatte B im Bereich einer Seitenkante S1 bzw. S2 mit Senkkopfschrauben SE verschraubbar.

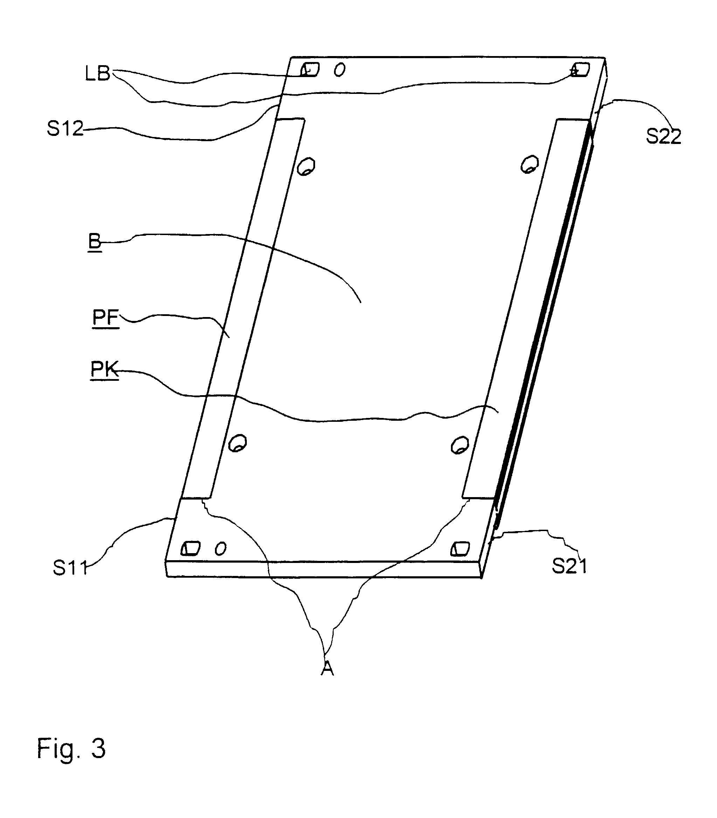

In Figur 3 ist eine Ausführungsvariante der erfindungsgemäßen Abdeckvorrichtung dargestellt, welche insbesondere bei Baugruppenträgern verwendbar ist. Dabei enthält die Grundplatte B wenigstens eine seitliche Aussparung A, in der eine Profilleiste PK bzw. PF annähernd bündig und parallel zu den äußeren Seitenkanten S11 und S12, bzw. S21 und S22 der Grundplatte B eingelegt ist. Bis zu den Ecken der Grundplatte B ragende Profilleisten PK bzw. PF sind hinderlich, um die Abdeckvorrichtung beispielsweise an oberen und unteren Quer- und/oder Längsschienen eines Baugruppenträgers zu befestigen. Somit weist die Grundplatte B beispielsweise an den oberen und unteren Seitenrändern jeweils die ebene Fläche ohne Profilschienen PK und PF auf, welche bei einer Befestigung der Abdeckvorrichtung an einem Baugruppenträger mittels Verschraubung mit Bohrungen LB versehen ist.

Insbesondere bei Baugruppenträgern kann eine elektromagnetisch abschirmende Abdeckvorrichtung gemäß der Erfindung beispielsweise als Frontplatte auch als eine rückseitige Abdekkung oder als eine vordere Blindabdeckung für nicht belegte Baugruppensteckplätze dienen.

Vorteil der erfindungsgemäßen Abdeckvorrichtung ist insbesondere die niedrige Höhe der separaten Profilleisten PK bzw. PF und die damit ideal in einer Ebene verlaufende elektromagnetische Abschirmung des metallischen Gehäuses, insbesondere bei mehreren, nebeneinander angeordneten Abdeckvorrichtungen. Die separate, als Federprofilleiste ausgebildete Profilleiste PF ist vorteilhaft so ausgebildet, daß nur eine einzige Ausführungsform einer einfach aufsteckbaren Kontaktfeder bei dem Gehäuse verwendet werden muß.

## Patentansprüche

1. Abdeckvorrichtung für ein elektromagnetisch abgeschirmtes metallisches Gehäuse, insbesondere für einen Baugruppenträger, mit
a) einer Grundplatte (B) und
b) mindestens einer Profilleiste (PK, PF), welche an eine Seitenkante (S1, S2) der Grundplatte (B) ansetzbar ist und aufweist
b1) einen annähernd orthogonal bezüglich der Ebene der Grundplatte (B) angeordneten leistenförmigen Kontaktschenkel (KS, KF) und
b2) einen leistenförmigen Auflageschenkel (AS), welcher mit der Grundplatte (B) verbindbar und derartig abgewinkelt ist, daß sich eine annähernde Bündigkeit der Profilleiste (PK, PF) mit der Vorderseite der Grundplatte (B) ergibt.

2. Abdeckvorrichtung nach Anspruch 1, wobei die Profilleiste (PK, PF) zwischen dem Kontaktschenkel (KS, KF) und dem Auflageschenkel (AS) einen annähernd bündig mit der Vorderseite der Grundplatte (B) abschließenden Abstandsschenkel (DS) aufweist.

3. Abdeckvorrichtung nach einem der vorangegangenen Ansprüche, wobei die Verbindung zwischen dem Auflageschenkel (AS) der Profilleiste (PK, PF) und der Grundplatte (B) im Bereich deren Seitenkante (S1, S2) durch Verschraubung (SE) erfolgt.

4. Abdeckvorrichtung nach einem der vorangegangenen Ansprüche, wobei die Grundplatte (B) wenigstens eine seitliche Aussparung (A) aufweist, in der die Profilleiste (PK, PF) annähernd bündig und parallel zu den äußeren Seitenkanten (S11, S12, S21, S22) der Grundplatte (B) eingelegt ist (Fig. 3).

5. Abdeckvorrichtung nach einem der vorangegangenen Ansprüche, wobei der nach hinten gerichtete leistenförmige Kontaktschenkel (KF) derart ausgebildet ist, daß von der Profilleiste (PF) federnd zur Seite abgespreizte Federelemente (F), insbesondere eine Kontaktfederleiste, aufsteckbar sind.

6. Abdeckvorrichtung nach einem der vorangegangenen Ansprüche, wobei der leistenförmige Kontaktschenkel (KS) der Profilleiste (PK) eine außen liegende Kontaktfläche (K) aufweist.

7. Abdeckvorrichtung nach einem der vorangegangenen Ansprüche, wobei an wenigstens zwei gegenüberliegenden Seitenkanten (S1, S2) der Grundplatte (B) jeweils eine Profilleiste (PK, PF) angeordnet ist.

## Claims

1. Screening device for an electromagnetically screened metal housing, in particular for a subrack, having
a) a base plate (B) and
b) at least one shaped strip (PK, PF), which can be joined to a side edge (S1, S2) of the base plate (B) and has
b1) a strip-shaped contact limb (KS, KF), which is arranged approximately orthogonally relative to the plane of the base plate (B), and
b2) a strip-shaped bearing limb (AS) which can be joined to the base plate (B) and is angled off in such a way as to make the shaped strip (PK, PF) approximately flush with the front side of the base plate (B).

2. Screening device according to Claim 1, in which between the contact limb (KS, KF) and the bearing limb (AS) the shaped strip (PK, PF) has a spacer limb (DS) terminating approximately flush with the front side of the base plate (B).

3. Screening device according to one of the preceding claims, in which the join between the bearing limb (AS) of the shaped strip (PK, PF) and the base plate (B) is made by a screw connection (SE) in the region of the side edge (S1, S2) of said base plate.

4. Screening device according to one of the preceding claims, in which the base plate (B) has at least one lateral recess (A) in which the shaped strip (PK, PF) is inserted approximately flush with and parallel to the outer side edges (S11 S12, S21, S22) of the base plate (B) (Figure 3).

5. Screening device according to one of the preceding claims, in which the strip-shaped contact limb (KF) directed rearwards is designed in such a way that spring elements (F), in particular a contact socket connector, resiliently spread out to the side from the shaped strip (PF) can be plugged on.

6. Screening device according to one of the preceding claims, in which the strip-shaped contact limb (KS) of the shaped strip (PK) has an externally situated contact surface (K).

7. Screening device according to one of the preceding claims, in which one shaped strip (PK, PF) is respectively arranged at at least two opposite side edges (S1, S2) of the base plate (B).

## Revendications

1. Dispositif de recouvrement pour un boîtier métallique à blindage électromagnétique, notamment pour un châssis équipé, comportant
a) une plaque (B) de base et
b) au moins une baguette (PK, PF) profilée, qui peut être rapportée sur un bord (S1, S2) latéral de la plaque (B) de base et comprend
b1) une branche (KS, KF) de contact en forme de baguette, disposée à peu près orthogonalement au plan de la plaque (B) de base,
b2) une branche (AS) d'appui en forme de baguette, qui peut être assemblée à la plaque (B) de base et est coudée de telle sorte qu'on obtient à peu près un affleurement de la baguette (PK, PF) profilée avec le côté avant de la plaque (B) de base.

2. Dispositif de recouvrement suivant la revendication 1, suivant lequel la baguette (PK, PF) profilée comporte, entre la branche (KS, KF) de contact et la branche (AS) d'appui, une branche (DS) d'écartement se terminant environ à fleur du côté avant de la plaque (B) de base.

3. Dispositif de recouvrement suivant l'une des revendications précédentes, suivant lequel l'assemblage entre la branche (AS) d'appui de la baguette (PK, PF) profilée et la plaque (B) de base s'effectue par vissage (SE) dans la région du bord (S1, S2) latéral de ladite plaque.

4. Dispositif de recouvrement suivant l'une des revendications précédentes, suivant lequel la plaque (B) de base comporte au moins un évidement (A) latéral, dans lequel la baguette (PK, PF) profilée est insérée environ à fleur et parallèlement aux bords (S11, S12, S21, S22) latéraux extérieurs de la plaque (B) de base (figure 3).

5. Dispositif de recouvrement suivant l'une des revendications précédentes, suivant lequel la branche (KF) de contact en forme de baguette, dirigée vers l'arrière, est conçue de telle sorte qu'on peut y enfiler des éléments (F) élastiques écartés élastiquement sur le côté de la baguette (PF) profilée, notamment une baguette élastique de contact.

6. Dispositif de recouvrement suivant l'une des revendications précédentes, suivant lequel la branche (KS) de contact en forme de baguette de la baguette (PK) profilée comporte une face de contact (K) extérieure.

7. Dispositif de recouvrement suivant l'une des revendications précédentes, suivant lequel une baguette (PK, PF) profilée respective est disposée sur au moins deux bords (S1, S2) latéraux opposés de la plaque (B) de base.
